# EUROPEAN PATENT SPECIFICATION

(11) **EP 0 506 925 B1**
(45) Date of publication and mention of the grant of the patent: **26.06.1996**
(21) Application number: 91918982.9
(22) Date of filing: 09.10.1991
(51) Int. Cl.: G06F 17/50

(54) **LOGIC SYNTHESIS with critical path analysis**
LOGIK-SYNTHESE mit Analyse des kritischen Pfads
SYNTHESE LOGIQUE avec analyse de chemin critique

(30) Priority: 18.10.1990 US 599967
(43) Date of publication of application: 07.10.1992
(73) Proprietor: Hewlett-Packard Company, Palo Alto, California 94304 (US)
(72) Inventor: CULBERTSON, Bruce, Palo Alto, CA 14306 4434 (US); SHACKLEFORD, Barry, Sunnyvale, CA 94087 (US)
(74) Representative: Powell, Stephen David
(86) International application number: US9107555
(87) International publication number: WO9207333

(56) References cited:
- IEEE SPECTRUM AUGUST 1989 pages 27 - 31; AART J. DE GEUS: 'Logic synthesis speeds asic design'
- 26TH ACM/IEEE DESIGN AUTOMATION CONFERENCE JUNE 25 - JUNE 29 1989 LAS VEGAS CONVENTION CENTER US pages 606 - 609; LIS ET AL: 'vhdl synthesis using structured modeling'
- HIGH PERFORMANCE SYSTEMS vol. 11, no. 2, February 1990, MANHASSET NY US pages 47 - 51; TITCHENER ET AL: 'specialized libraries ease complex dsp design'
- 25TH ACM/IEEE DESIGN AUTOMATION CONFERENCE JUNE 12 -JUNE 15 1988 ANAHEIM CONVENTION CENTER pages 154 - 159; WALLACE ET AL: 'atv : an abstract timing verifier'
- Synthesis and Simulation Conf., Kyoto, Japan, Oct. 23rd, 1990; Culbertson et al.: "Hewlett-Packard Logic Synthesis" in "VLSI Logic Synthesis and Design" by R.W. Dutton.
- IEEE Design and Test, December 1986, pages 13-25; H. de Man et al.: "Cathedral-II: A Silicon Compiler for Digital Signal Processing"
- The Electronic System Design Magazine, June 1988, pages 27-34; Eng-Kee Kwang: "Optimized ASICS for the Ears".

## Description

### BACKGROUND OF THE INVENTION

The present invention relates generally to computer-aided design and more particularly to a computerized system for designing logic circuits.

Computer-aided design systems have greatly improved the productivity of design engineers in various engineering arts. A disadvantage of such systems in the context of the design of logic circuits is that they function at much too low a level of abstraction, thereby requiring the designer to spend much time on minor details of circuit design. In addition, once such a design has laboriously been completed, it can rarely be adapted to improved component technologies. Accordingly there is a need for a high level computerized logic synthesis system.

The following article, viz IEEE Design and Test, December 1986, pages 13-25; H. de Man et al.: "Cathedral-II: A Silicon Compiler for Digital Signal Processing" discloses a logic synthesis system starting from a functional outline of the logic system to be synthesised, wherein the system comprises module generators (see Figs. 10 to 12 of the article) and critical path analysis means (see Fig. 18 of the article). The disclosure of this document corresponds generally to the introductory part of claim 1.

### SUMMARY OF THE INVENTION

According to the present invention, there is provided a computerized logic synthesis system for synthesizing a logic circuit design from a functional outline, the system comprising: computer means including means for receiving a functional outline from an operator, a plurality of tunable module generators, each operative to produce a design of one general type of circuits, and critical path analysis means, characterized in that the critical path analysis means comprises means for generating a topology graph with nets drawn as straight lines between gates, the graph depicting a critical path through a synthesized logic circuit, such that in the topology graph, the horizontal coordinate of a gate is set to be proportional to the delay of the longest path from the inputs of the logic circuit to that gate.

The present invention provides a high level computerized logic synthesis system that synthesizes a complete circuit design based on a functional outline provided by a system designer. In a preferred embodiment a system according to the invention includes:
a plurality of tunable module generators, each operative to produce a design of one general type of circuits such as multipliers, shifters, logic gates, and the like;
means for generating a topology graph having lines between gate levels to show the designer a critical path through any of a plurality of synthesized logic circuits; and
a plurality of virtual instruments, operable by the designer to simulate operation of a synthesized logic circuit and to observe the performance of the circuit.

Other aspects and advantages of the present invention will become apparent from the following detailed description, taken in conjunction with the accompanying drawings, illustrating by way of example the principles of the invention.

### BRIEF DESCRIPTION OF THE DRAWINGS

FIGURE 1 is an illustration of optimization rules utilized by module generators according to the present invention. Optimization rules are pairs of patterns. If the first pattern of a rule matches a fragment of the design, the fragment is repolaced by the second pattern.

FIG. 2 is an illustration of providing a synthesized, realizable network to replace a functionally-designed logic gate having excess fan-in by means of technology backend according to the present invention. A single gate with excessive fan-in is replace by a tree of gates the by the technology backend. In this example the fan-in limit is two. The shape of the tree and the points where nets enter it are carefully chosen to avoid increasing delay.

FIG. 3 illustrates topology graphs showing critical paths through synthesized logic networks. In the topology graph, delay increases with the x dimension. Displayed are unmapped 16-bit shifters with orgainizations of (16), (4 4), and (2 2 2 2) respectively.

FIG. 4 illustrates two virtual instruments as presented on a visual display screen of a system according to the invention. Two virtual instruments, the data generator and the data viewer are shown. Presently, the data viewer can present a data bus as an analog wave form or a digital logic scope display.

FIG. 5 illustrates a logic synthesis environment according to the invention. The environment illustrates the design and simulation of a digital low-pass filter in this example.

### DESCRIPTION OF THE PREFERRED EMBODIMENT

The invention is described in detail in the following pages. The present invention, Logic Synthesis is a new system for digital hardware design which includes many features to speed the development of new products. Design entry and simulation environments have been created which focus the designers attention at the application-level add hide low-level implementation details. Designs, captured as technology-independent block diagrams, are automatically translated to gate-level designs by a collection of module generators plus supporting tools. The high speed of Logic Synthesis encourages experimentation and an iterative design approach.

Logic Synthesis assists and automates the process of refining digital designs from high level, abstract conceptions to low-level, concrete specifications for their physical implementation. Input to Logic Synthesis is expressed as block diagrams, composed of adders, multiplexers, shifters, register files, and so forth. Logic Synthesis transforms block diagrams into efficient, electrically and functionally correct, net lists which can be implemented in various technologies.

The most obvious benefit of Logic Synthesis is that it reduces the time needed to develop a new product. In a competitive market, the time needed to develop a product often has a higher influence on profitability than the product's performance or factory cost. In addition to reducing the design phase of the development schedule, Logic Synthesis can also reduce the debugging and testing phases by eliminating the errors that inevitably occur when a gate-level design is produced manually.

A disadvantage of the traditional digital design process is that designs are not captured precisely until they have been refined to too low a level of abstraction. At this point, technological dependencies have been introduced and high-level functions have been obscured. Experience has shown that these designs can almost never be reused to take advantage of faster and cheaper technologies when they become available. In contrast, HPLS accepts a high-level, technology-independent design, and automatically maps it to the target technology. Reusing an old design can be as simple as rerunning the synthesis tools.

A designer who has been freed from the tedious low-level design tasks can devote increased time to the more profound system-level design issues which can more significantly influence performance. Research into the art of implementing a specific function, for example an adder, needs to be performed only once to embed it into Logic Synthesis, after which it becomes available to all users of the system.

The initial focus of Logic Synthesis is to assist the design of application specific integrated circuits. ASIC vendors typically provide low-level tools for placement and routing, rule checking, add so forth. Logic Synthesis is intended to complement and augment such tools, rather than duplicate them. Thus, the output of Logic Synthesis is the set of files which a vendor needs to produce an integrated circuit.

After it is entered with a graphical editor, the block diagram describing the circuit is translated to a technology specific net list in two steps. In the first step, module generators expand the blocks into a generic net list of simple gates. During the second step, a technology backend manipulates the generic net list into a new net list which satisfies the design rules of the target technology, and exploits the technology's special features. The heart of Logic Synthesis is a library of module generators, each of which can translate blocks of a single functional type into a collection of simple generic gates. The library contains module generators for all the kinds of blocks which are typically used to construct computer data-paths and control logic. There are currently about fifty module generators, including: Adders, ALU'S, Comparators, Decrementers, Decoders, Dividers, Encoders, Incrementers, Multipliers, Multiplexers, Random Logic, Register Files, Selectors, Shifters, and State Machines.

It is important to stress that the library is not composed of fixed designs, as are standard cell and gate array libraries; instead, it is composed of generators which can produce an endless variety of fixed designs. For example, blocks are synthesized with exactly the desired operand lengths. By adjusting the parameters given to the module generators, the designer tunes the synthesized circuit to achieve the project's cost and performance objectives. The speed of the synthesis process permits many design choices to be tried, with actual cost and performance data gathered for each. To produce a product upgrade, the current design can be reused, with blocks regenerated using synthesis parameters which yield higher performance. The new product is functionally equivalent to the first; consequently, the need for simulation and testing is reduced.

There exists extensive literature describing the implementation of data-path and control logic functions, and much of this knowledge has been incorporated into the generators. Often there exist several algorithms which can be used to implement a

**Table 1:**

| Different structures for a 16-bit shifter, synthesized under user control, result in a variety of gate counts and delays. This data was collected in fifteen minutes of experimentation with Logic Synthesis. | | | | | | |
|---|---|---|---|---|---|---|
| | Organization | (16) | (2 8) | (4 4) | (2 4 2) | (2 2 2 2) |
| Generic Gates | Fan-in_{avg} | 2.6 | 2.3 | 2.2 | 2.0 | 1.9 |
| | Fan-inₘₐₓ | 16 | 8 | 4 | 4 | 2 |
| | Fan-out_{avg} | 1.9 | 2.0 | 1.9 | 1.9 | 1.8 |
| | Fan-outₘₐₓ | 16 | 16 | 16 | 16 | 16 |
| | Levels | 5 | 6 | 6 | 7 | 9 |
| | Gates | 300 | 209 | 172 | 186 | 200 |
| CMOS Gates | Fan-in_{avg} | 2.1 | 2.0 | 2.0 | 2.0 | 1.8 |
| | Fan-inₘₐₓ | 10 | 6 | 4 | 4 | 2 |
| | Fan-out_{avg} | 2.0 | 1.9 | 1.8 | 1.9 | 1.7 |
| | Fan-outₘₐₓ | 9 | 8 | 8 | 8 | 8 |
| | Levels | 9 | 9 | 7 | 7 | 9 |
| | Gates | 474 | 334 | 257 | 244 | 251 |
| | Cells | 575 | 345 | 236 | 219 | 212 |
| | Relative Delay | 1.00 | 1.094 | 1.037 | 1.068 | 1.087 |

given function. For example, the module library includes ripple-carry adders, carry look-ahead adders, and conditional sum adders. Multipliers can be synthesized using iterative cellular arrays, or carry-save adder arrays. Best of all, the designer needs little understanding of the alternatives since an are functionally the same and since fast synthesis provides a quick comparison of cost and performance.

Once an algorithm is chosen, there often remain a number of structural choices which can influence cost and performance. As an example, a 16-bit one directional shifter will be considered in detail. The shifter has 16-bit input and output data buses. There are also four weighted shift-amount inputs and a shift-in input.

In the case of the shifter, the library has only one algorithm--it will be implemented as a collection of n-to-l multiplexers. There are many possible structural arrangements of the multiplexers, however, which will produce the desired shifter. For example, the shifter could be structured as one level of sixteen 16-to-1 multiplexers, or two levels, each composed of sixteen 4-to-1 multiplexers. In fact, each factorization of the number sixteen yields a different way to structure the shifter. For example, the factorization (2 8) corresponds to a shifter with a level of 2-to-1 multiplexers and a level of 8-to-1 multiplexers.

Table 1 contains data for a selection of structures for the shifter. The speed advantage of the (16) structure, which is significant in the technology-independent form, becomes less pronounced after the technology back end corrects the excessive fan-in and fan-out. Good compromises between gate count and speed are offered by both (2 2 2 2) and (4 4); (2 2 2 2) may be favored in a technology providing only 2-input gates.

Module generators provide designers with custom produced functional blocks with exactly the required operand sizes. Designers may choose from a large number of functions. Given a function, a number of algorithmic and structural choices are usually available.

The technology back ends perform two functions: optimization and mapping. Optimization improves the cost and performance of a circuit. Mapping converts the net list of generic gates, produced by the module generators, into an electrically correct net list of gates which can be implemented in the target technology. Mapping is necessary be cause the module generators use gates chosen from a fixed set of functions which may be different from those available in the target technology. Also, the module generators assume gates may have unlimited fan-in and fan-out. The technology back ends allow Logic Synthesis to realize an important goal: the ability to implement one design efficiently in multiple technologies.

Our experience with Logic Synthesis has shown that relatively simple back ends are most effective. We have tried other systems with far more sophisticated optimization features. These systems can considerably improve a poor design, though often the result still leaves much to be desired. For example, no system we have seen will convert a ripple carry adder to a carry look-ahead adder. However, if the design is nearly optimal to begin with, then the best optimizers can improve it very little. Furthermore, these systems are so slow, even working on small circuits, that they discourage the experimentation and iterative design approach that we wish to promote.

Logic Synthesis designs are, in fact, nearly optimal before they reach the technology back ends. Because the implementation of data-path structures, like adders, has evolved to a very high art, and because our module generators have captured that art, circuits produced by the generators typically have excellent fan-in, fan-out, and cost-performance characteristics . For control logic, Logic Synthesis uses generators which include their own optimization algorithms. Since these blocks typically contain relatively few gates, the optimization performed by the module generators is quick and effective.

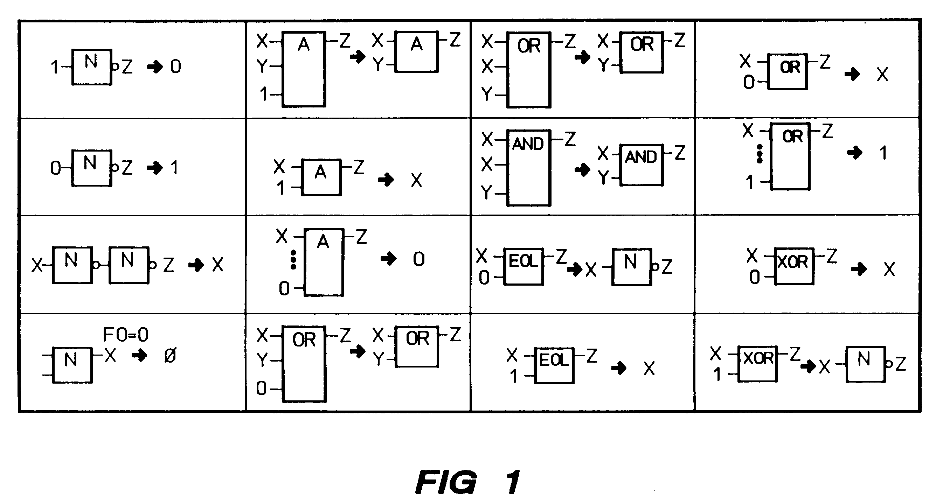

Both the mapping and optimization applied by the technology backends involve only small numbers of adjacent gates at a time. These transformations, called peep-hole optimization, can be performed far more quickly than the global optimization used in some other systems. Most of the transformations can be specified as rules, each of which is a pair of patterns. The design is searched for collections of gates which match the first pattern in a rule. The collection of gates is then replaced with the second pattern in the rule. See Figure 1.

A gate with excessive fan-in must be replaced, by the technology backends, with trees of low fan-in gates which implement the same function. To avoid increasing delay, nets on the critical path should enter the fan-in tree at its root while nets with plenty of slack can enter the tree at a deeper level. Slack is a measure of how critical the timing is at a gate or net, with zero slack being most critical. It is defined as the difference between the length of the longest path through the gate or net and the length of the critical path.

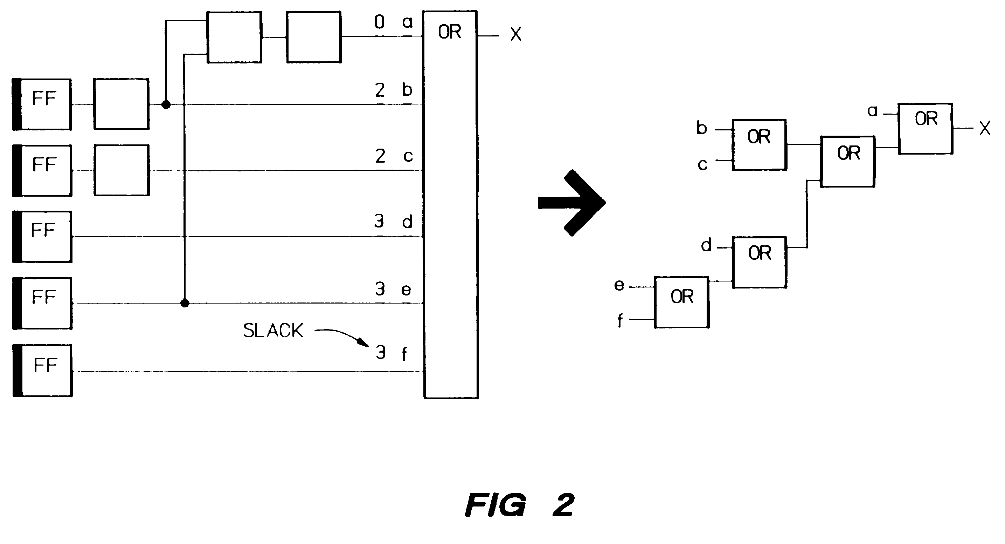

Fixing excessive fan-out is analogous: the net with too many loads is replaced with a tree of buffers plus the original driver, which serves as the root. In this case, loads should be driven by gates at a tree depth not greater than the slack through the load. An algorithm has been developed which builds optimal fan-in and fan-out trees. Optimal in this case means that no tree can be found which has less impact on the critical path. Figure 2 illustrates the construction of an optimal fan-in tree.

A great deal of effort was put into creating a system that would synthesize and map designs rapidly. On an HP-9000/370 workstation (an 8 VAX MIPS machine), synthesis and mapping proceeds at several hundred gates per second. To complement this system, we wished to design a human interface that would evoke the intuition and even the playfulness of the designer. Our intent was that the designer would read the instructions after using the system.

As massive VLSI becomes more prevalent, a way must be found to manage the complexity of million-gate systems on a chip. We wish to elevate the designer's perspective by encouraging optimization at the system level rather than at the gate or transistor level.

Nearly all substantial designs start out as block diagrams. We have chosen this natural form of expression as the principal form of design specification within Logic Synthesis. This being natural, in any case, to artists, engineers, and other right-brained individuals.

The design is entered via a block diagram drawing editor. The editor allows the designer to freely create, copy, move, delete, and connect graphical block diagram objects. A block diagram object can be a wire or bus connecting two or more modules, the actual module itself, or even a list of logic equations. It may seem ironic that we are encouraging users to use a textual method to specify control logic. We feel, simply, that control logic is more efficiently entered and understood by others as logic equations. Future versions of Logic Synthesis will allow fastidious users to alter the graphical presentation of any block diagram object. In addition, tuning parameters for modules are also specified via the block diagram editor.

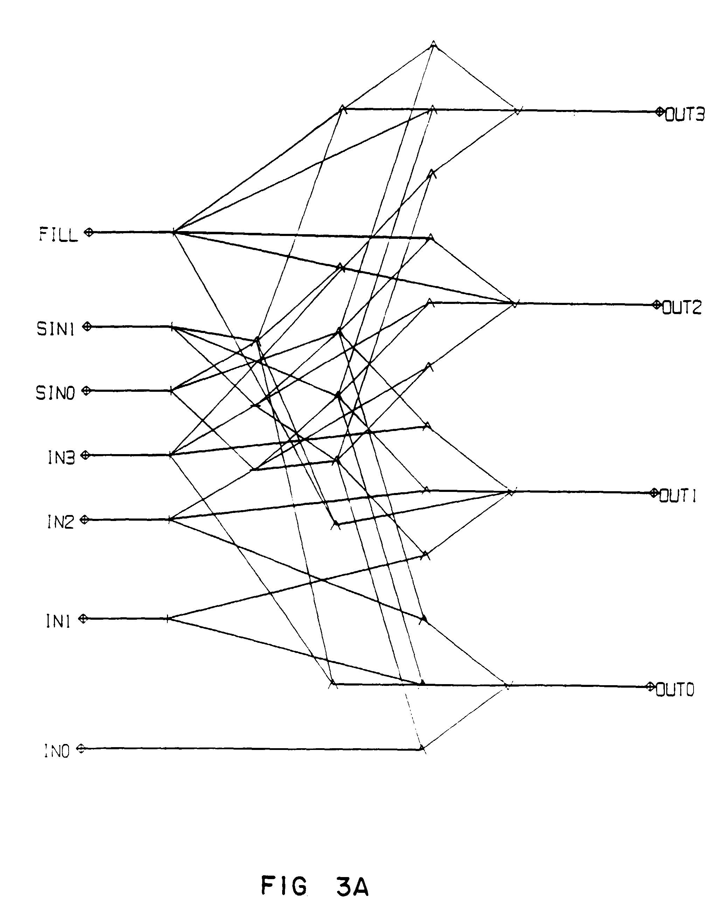

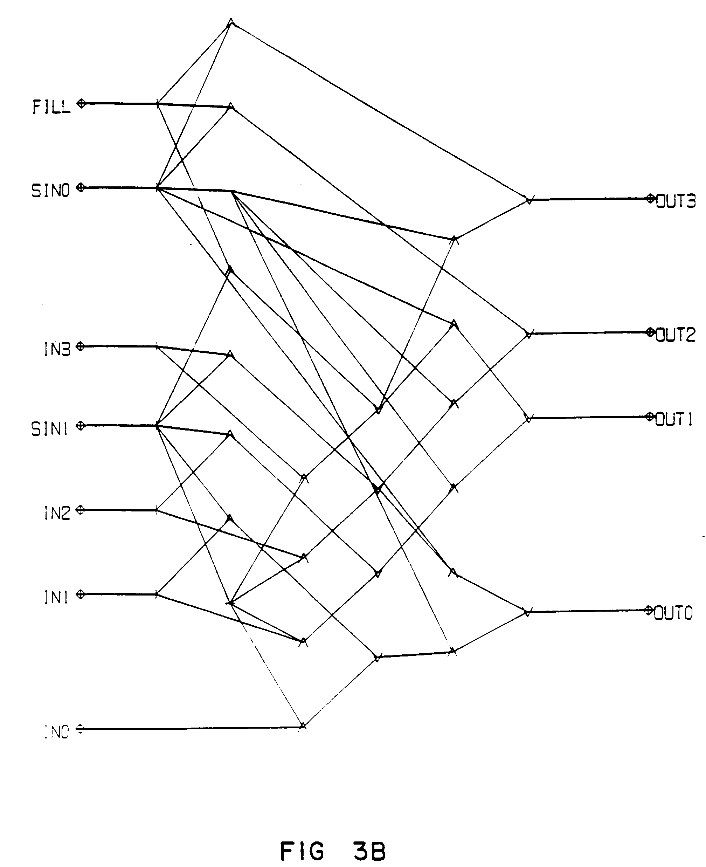

After the design has been synthesized, the designer can rapidly obtain an overview of the circuit by viewing a presentation form that we call the topology graph. The topology graph presents a gestalt of the design where the entire design is plotted in a single window with nets drawn as straight lines between the gates. Color or line-style is used to indicate slack on the nets, with the critical path highlighted the most. Figure 3 is an example of a topology graph.

A topology graph is constructed in the following manner: Circuit inputs are placed in a column on the left side of the schematic. The horizontal coordinate of a gate is set to be proportional to the delay of the longest path from the inputs to that gate. Registers appear twice on the diagram. First they are drawn in the input column with only the register outputs shown. They appear again, with only the register inputs drawn, at the right end point of one or more paths through the circuit.

Circuit details are lost in the topology graph, but performance characteristics are strikingly illuminated. It becomes obvious that the portion of the design critical to timing is not a single path, as suggested by most timing analysis tools, but instead is an envelope of paths, all with approximately the same length. Delay through the entire circuit can be improved with the least amount of redesign, or the least increase in power dissipation, by modifying the narrow portions of the envelope. When no narrow regions remain, little can be done to further improve performance.

The Topology Graph is viewed with a Topology Viewer. The Topology Viewer allows the designer to view the entire Topology Graph or zoom-in to examine specific regions. High-resolution hard copy can also be obtained. Future versions of the Topology Viewer will allow a designer to point at a specific node (i.e., gate) on the graph and determine what module generated that gate. A description of the algorithm used for topology plotting is appended to the specification as Appendix I.

An integral component of Logic Synthesis is a compiled gate-level simulator that assumes unit delay through all elements. The objective of the Simulator is to provide the designer with the means to rapidly verify the logical correctness of the design. The performance of the simulator is roughly 1,000,000 gate evaluations per second on an HP-9000/370 workstation (an 8 VAX MIPS machine). Timing verification is best done topologically with tools like the Topology Graph Viewer or with technology-specific timing analysis tools. The operation of the Simulator is closely linked to the Data Generator and Data Viewer virtual instruments described below.

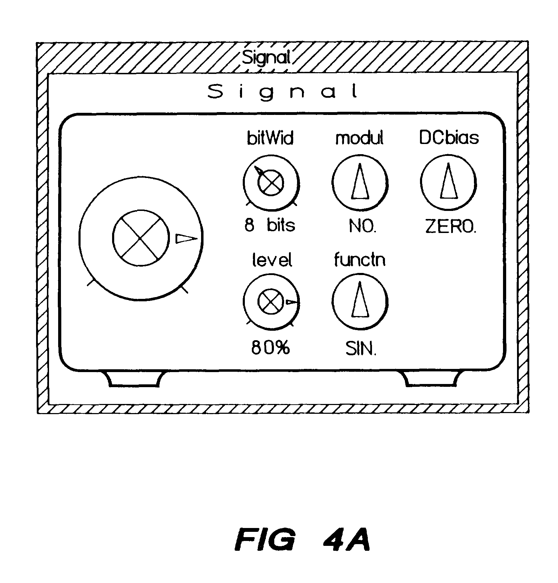

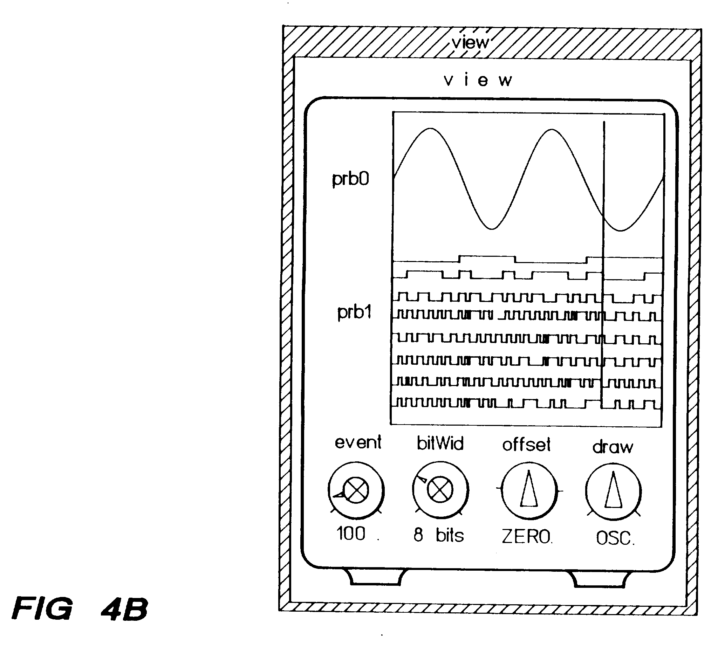

By providing a set of versatile virtual instruments, we hope to move the designer closer to the application domain and away from the Boolean logic domain. Presently we have two prototype virtual instruments: the Data Generator and the Data Viewer as shown in Figure 4. As currently configured, these instruments are perhaps most applicable to a digital signal processing application. However, extensions that are more generally useful, as well as new instruments, are planned.

The Data Generator is a means of applying stimuli to the Simulator. Currently the Data Generator is modeled after a conventional analog signal generator: there are multiple variable-period waveforms available (e.g., sine, triangle, or square) whose output amplitude is variable and can be biased above or below the zero level. The Data Generator's output bus width (i.e., quantization) is selectable from the Data Generator front panel. An additional useful feature is that the output of one generator can be fed into another and summed with its output to produce complex waveforms. A planned extension will allow the Data Generator to take its output from a prepared file.

The Data Viewer is a multi-mode, multi-channel data display instrument. The current prototype has two modes implemented. The first mode resembles a conventional logic analyzer display with a single high/low display trace per bit of input bus. The second mode is an oscilloscope-like analog display where the input data bus is treated as a binary fraction that varies between zero and one. In both modes, the resolution (or trace speed) is variable. The Data Viewer automatically increases the number of display channels as more input buses are connected to the instrument. Planned extensions for the Data Viewer include a variable base numeric mode and a character mode. The high speed of the simulator makes instruments like the Data Viewer practical and allows the designer to participate in an interactive environment.

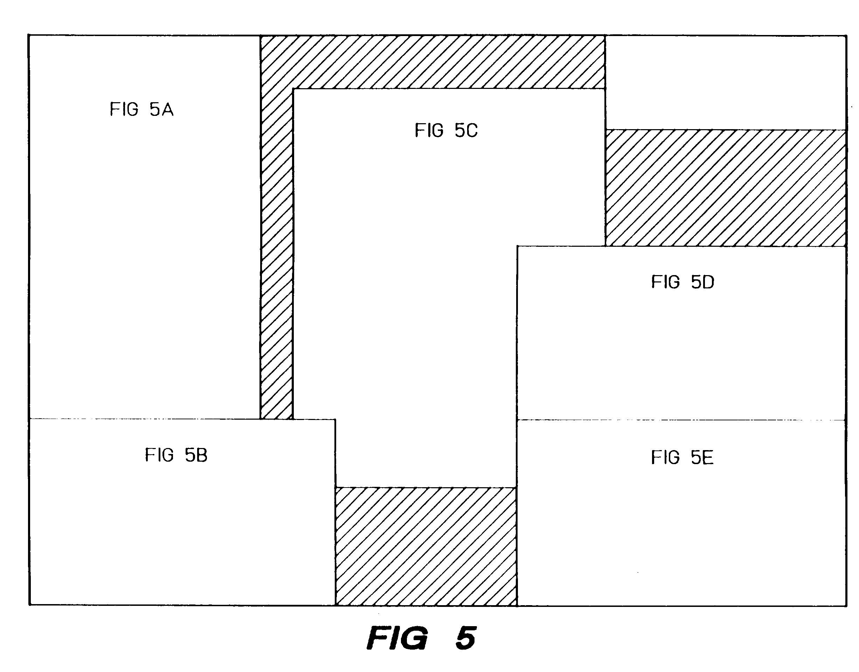

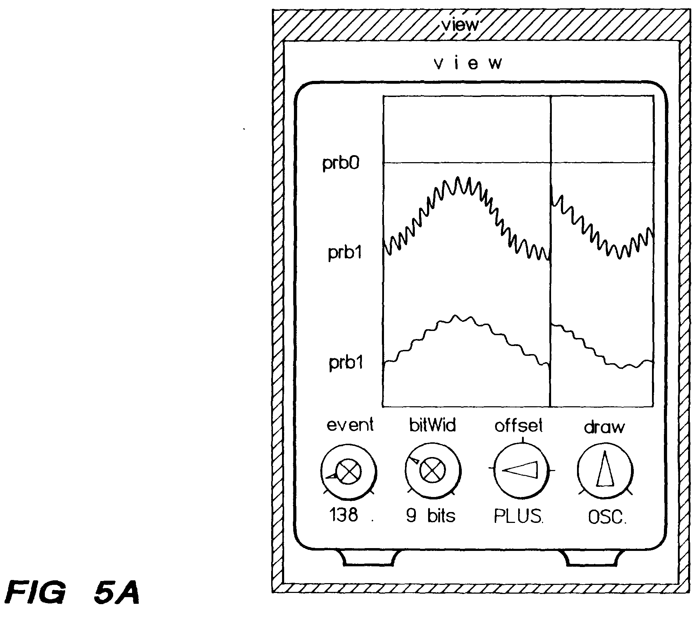

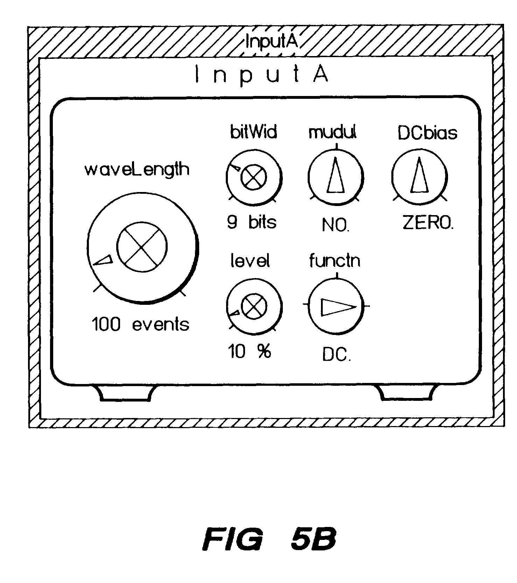

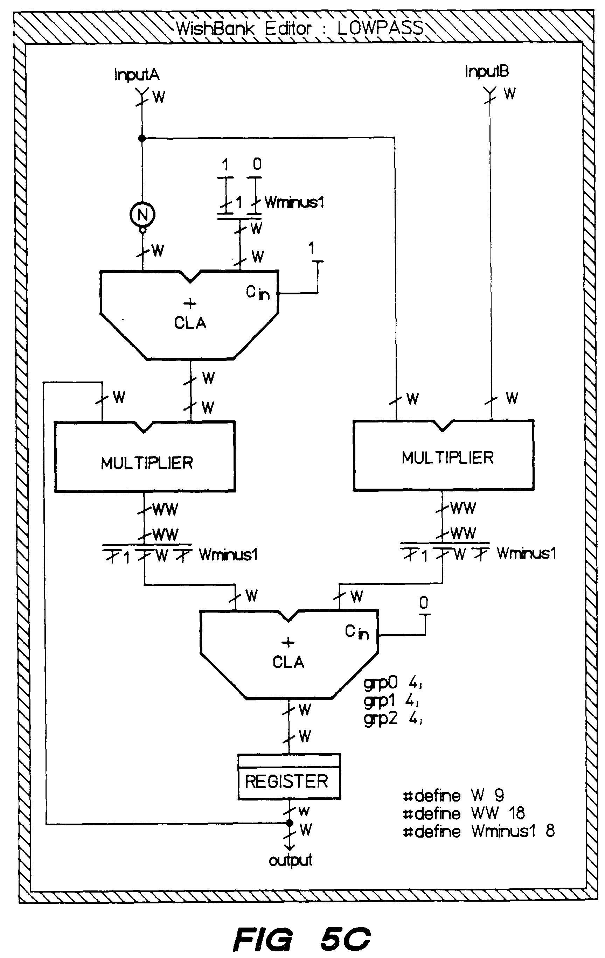

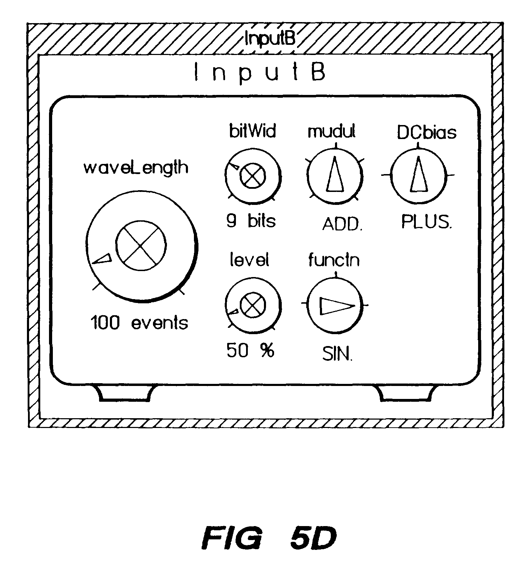

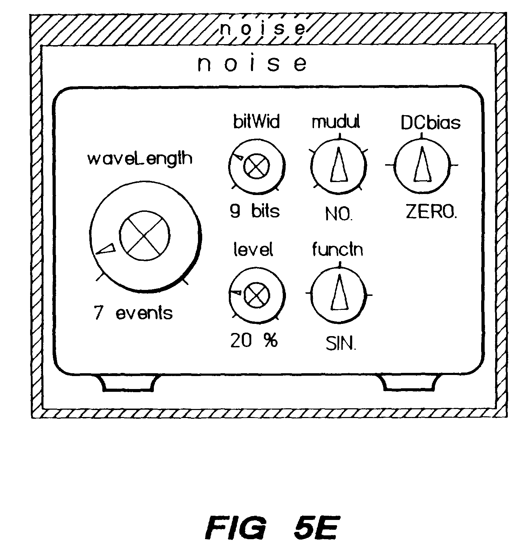

Figure 5 illustrates a logic synthesis session that has progressed to the point of logic simulation. The example is that of a simple low-pass filter. Instead of streams of ones and zeros that normally associated with logic simulation, we see waveforms: an appropriate form to view the input and output of a digital filter. The illustrated low-pass filter takes a percentage of the previous input and sums it with one minus that percentage times the current output to form the next output. This may be expressed as Oₜ=kIₜ₋₁+(1-k)Oₜ₋₁ ; where k varies from 0 to 1 but is usually about .1, O is the filter's output, and I is the filter's input.

We can see that the major design parameters are indeed parameters. So the designer can, for example, explore the effects of quantization by changing the input bus width parameter and then resynthesizing the design--a process that takes less than a minute. The other major parameter is the percentage of the previous output used to compute the next output. Rather than laboriously type the constant and one minus the constant for each trial, the designer has added hardware to the circuit to compute these two values. The constant can then be applied from a data generator and varied in real time while the simulation is progressing.

After the design has been simulated to satisfaction, the final synthesis can be performed. Here, the actual binary constant selected during simulation will be entered. There is no need to remove the superfluous adder--since both of its inputs are now constants, all of its gates will be removed by the optimizer. The multipliers will also be affected by the optimizer, since each multiplier has a constant as one of its inputs. The final task is then to select a particular technology-specific library and perform the technology mapping. For this example, a nine-bit filter, the initial synthesis resulted in a design of 1401 gates. After mapping and optimization, the design was reduced to 649 gates.

In this example, a designer who was familiar with filter design (but not necessarily familiar with multiplier design) was able to enter and synthesize a design for a low pass digital filter in about ten-minutes. Subsequently, different bit width designs were explored by simply changing the bus width parameter. In order to observe the effect of the feedback constant in real time, extra hardware was added to the design to save the designer's time. This hardware did not penalize the design because it was later completely removed by the optimizer. In an hour the designer was able to intuitively explore literally dozens of designs without becoming enmeshed in the intricacies of gate level design. Essentially all of the designer's creativity and intuition was focused in the application domain.

Logic Synthesis provides a set of fast and efficient tools for logic synthesis, simulation, and design visualization. The graphical nature of the human interface allows designs to be expressed quickly by the designer. Rapid synthesis and mapping encourage the designer to interactively explore the design space in search of an optimum system configuration. Applying creativity where it will have the greatest impact, the designer remains focused in the application domain, knowing that optimization and mapping into the chosen technology will be automatic. Designs produced by Logic Synthesis are inherently reusable.

### Appendix I: Description of the Algorithm used for Topology Plotting

It is assumed that the circuit is not partitioned, i.e., for any two gates in the circuit, there is a sequence of nets which connects the two gates.

### Topology-plot (

Call Build-graph.

Call Split-registers.

Call Assign-x-coords.

MPL = most populous level, the level with the most gates.

Call Assign-y-coords-MPL.

Call Assign-y-coords-using-drivers (MPL+l, (maximum level)).

Call Assign-y-coords-using-loads (MPL-l, ).

// At this point, networks of gates which only drive outputs //with level less than MPL have still not been assigned y-//coordinates. The next step assigns y-coordinates to all//remaining gates.

Call Assign-y-coords-using-drivers (l, MPL-l).

// At this point, all coordinates are known and the plotting //can begin.

Draw all gates.

Call compute-slack.

Draw all edges. Emphasis is used in inverse proportion to slack.
}

### Build-graph {

The net list is read from a file. An in-memory graph is constructed. The nodes in the graph represent the gates in the circuit. An edge connects two gates G1 and G2 if a net connects an output of G1 to an input of G2 or a net connects an output of G2 to an input of G1.
}

### Split-registers {

Registers are split into two gates. One has all the inputs from the original gate and no outputs. The other has all the outputs from the original gate and no inputs. It is assumed that this will eliminate all cycles from the graph.
}

### Assign-x-coords {

Every gate is assigned a level. The level is used as the x-coordinate for plotting the gate. Gates with no inputs are assigned a level of zero. A gate with inputs is assigned a level one greater than the maximum of the levels of the gates which drive its inputs.
}

Assign-y-coords-MPL {
y = 0
for each gate G taken in order from the net list {
if (level of G) - MPL {
(y coordinate of G) = y
y = y + 1
}
}
}

Assign-y-coords-using-drivers (first, last) {
for L = first to last {

Call Assign-y-coords-using-drivers-preliminary (L).

Call Adjust-colliding-gates (L).
}
}

Assign-y-coords-using-drivers-preliminary (L) {
for every gate G with (level of G) = L and
unassigned y-coordinate {

G-drivers = set of gates which 1) drive G and 2) already have been assigned y-coordinates.

(y-coordinate of G) = weighted average of y-coordinates of gates in G-drivers. The average weighs most heavily the gates in G-drivers with levels closest to the level of G.
}
}

Assign-y-coords-using-loads (first, last) {
for L = first to last {

Call Assign-y-coords-using-loads-preliminary (L).

Call Adjust-colliding-gates (L).
}
}

Assign-y-coords-using-loads-preliminary (L) {
for every gate G with (level of G) = L

G-loads = set of gates which 1) are driven by G and 2) already have been assigned y-coordinates.

if G-loads is not empty {
(y-coordinate of G) = weighted average of y-coordinates of gates in G-loads. The average weighs most heavily the gates of G-loads with levels closest to the level of G.
}
}
}

### Adjust-colliding-gates (L) {

There is a minimal spacing allowed between gates in the plot. New y-coordinates are assigned which 1) are as close as possible to the preliminary y-coordinates and 2) satisfy the minimum spacing requirement. Any gates which have not been assigned preliminary y-coordinates are ignored (and will be treated on a subsequent pass).
}

### Compute-slack {

For each output gate G {
(slack at G) = (maximum level) - (level of G)
}
while there are gates with unassigned slack {
Find a gate G 1) with unassigned slack and 2) which only drives gates with assigned slack. Create a set S of numbers with one number N for each gate D driven driven by G. N = (slack at D) + (level of D) - (level of G) - 1. (slack at G) = minimum of numbers in set S.
}

Suppose a graph edge connects gates G1 and G2, and the level of G2 is greater than the level of G1.
Then the slack on the edge is (slack at G2) + (level of G2) - (level of G1) - 1.
}

## Claims

1. A computerized logic synthesis system for synthesizing a logic circuit design from a fractional outline, the system comprising: computer means including means for receiving a fractional outline from an operator, a plurality of tunable module generators, each operative to produce a design of one general type of circuits, and critical path analysis means, characterized in that the critical path analysis means comprises means for generating a topology graph with nets drawn as straight lines between gates, the graph depicting a critical path through a synthesized logic circuit, such that in the topology graph, the horizontal coordinate of a gate is set to be proportional to the delay of the longest path from the inputs of the logic circuit to that gate.

## Patentansprüche

1. Ein computerisiertes Logiksynthesesystem zum Synthetisieren eines Logikschaltungsentwurfs von einer Funktionsskizze, wobei das System folgende Merkmale aufweist: eine Computereinrichtung, die eine Einrichtung zum Empfangen einer Funktionsskizze von einem Betreiber aufweist, eine Mehrzahl von abstimmbaren Modulgeneratoren, von denen jeder wirksam ist, um einen Entwurf eines allgemeinen Typs von Schaltungen zu erzeugen, und eine Kritischer-Weg-Analyseeinrichtung,
dadurch gekennzeichnet,
daß die Kritischer-Weg-Analyseeinrichtung eine Einrichtung zum Erzeugen eines Topologiegraphen mit Netzen, die als gerade Linien zwischen Gattern gezeichnet werden, aufweist, wobei der Graph einen kritischen Weg durch eine synthetisierte Logikschaltung darstellt, derart, daß die Horizontalkoordinate eines Gatters in dem Topologiegraph proportional zur Verzögerung des längsten Wegs von den Eingängen der Logikschaltung zu diesem Gatter eingestellt ist.

## Revendications

1. Un système informatisé de synthèse logique destiné à synthétiser une conception de circuit logique à partir d'un tracé fonctionnel, le système comprenant: un moyen calculateur qui inclut un moyen destiné à recevoir d'un opérateur un tracé fonctionnel, une série de générateurs de modules susceptibles d'être accordés, exerçant chacun une fonction de production d'une conception d'un type général de circuits, et un moyen d'analyse de chemin critique, caractérisé en ce que le moyen d'analyse de chemin critique comprend un moyen de génération d'un graphe de topologie à réseaux dessinés sous la forme de lignes droites entre des portes, le graphe représentant un chemin critique à travers un circuit logique synthétisé, d'une manière telle que la coordonnée horizontale d'une porte dans le graphe topologique est définie de manière à être proportionnelle au retard du plus long des chemins entre les entrées du circuit logique et cette porte.
